# EUROPEAN PATENT APPLICATION

(11) **EP 4 496 446 A1**
(43) Date of publication of application: **22.01.2025**
(21) Application number: 23890068.2
(22) Date of filing: 18.04.2023
(51) Int. Cl.: H10B 12/00

(54) **SEMICONDUCTOR STRUCTURE, AND METHOD FOR MANUFACTURING SEMICONDUCTOR STRUCTURE**

(30) Priority: 14.11.2022 CN 202211419426
(71) Applicant: CXMT Corporation, Hefei, Anhui 230601 (CN)
(72) Inventor: YANG, Mengmeng, Hefei, Anhui 230601 (CN); TANG, Yi, Hefei, Anhui 230601 (CN)
(74) Representative: Gulde & Partner
(86) International application number: PCT/CN2023/089012
(87) International publication number: WO 2024/103624

(57) **Abstract**

Disclosed are a semiconductor structure and a method for manufacturing the semiconductor structure. The semiconductor structure includes a base substrate provided thereon with stacks and first isolation layers alternately arranged in a first direction. The stack includes active structures and second isolation layers alternately arranged in a third direction. The active structure is provided with two first recesses therein. In the third direction, a thickness of the first recess is the same as a thickness of the active structure. The active structure is provided with one capacitor on each of opposite sides thereof, and the capacitor includes an upper electrode, a dielectric layer, and a lower electrode. The lower electrode is located on an inner wall of the first recess. The upper electrode is located between two adjacent stacks and is arranged opposite to the first recess, and the upper electrode also penetrates through the first isolation layer.

## Description

### CROSS-REFERENCE

The present application claims priority to Chinese Patent Application No. 202211419426.1 entitled "SEMICONDUCTOR STRUCTURE AND METHOD FOR MANUFACTURING SEMICONDUCTOR STRUCTURE" and filed on Nov. 14, 2022, the content of which is incorporated herein by reference in its entirety.

### TECHNICAL FIELD

Embodiments of the present disclosure belong to the field of semiconductors and particularly relate to a semiconductor structure and a method for manufacturing the semiconductor structure.

### BACKGROUND

Embodiments of the present disclosure provide a semiconductor structure and a method for manufacturing the semiconductor structure, which are at least beneficial for simplifying the manufacturing process of a capacitor of a DRAM and improving the capacity of the capacitor.

According to some embodiments of the present disclosure, in one aspect, the embodiments of the present disclosure provide a semiconductor structure, where the semiconductor structure includes a base substrate. The base substrate is provided thereon with a plurality of stacks and a plurality of first isolation layers alternately arranged in a first direction. The stack includes a plurality of layers of active structures and a plurality of second isolation layers alternately arranged in a third direction and all extending in a second direction, where the first direction and the second direction are parallel to an upper surface of the base substrate, and the third direction is perpendicular to the upper surface of the base substrate. The active structure is provided with two first recesses therein, and the two first recesses are respectively located on opposite sides of the active structure in the first direction. In the third direction, a thickness of the first recess is the same as a thickness of the active structure. The active structure is provided with one capacitor on each of opposite sides thereof in the first direction, and the capacitor includes an upper electrode, a dielectric layer, and a lower electrode, where the lower electrode is located on an inner wall of the first recess, the upper electrode is located between two adjacent stacks and is arranged opposite to the first recess, the upper electrode also penetrates through the first isolation layer, and the dielectric layer is located between the lower electrode and the upper electrode.

According to some embodiments of the present disclosure, in another aspect, the embodiments of the present disclosure provide a method for manufacturing a semiconductor structure. The method includes: providing a base substrate and forming, on the base substrate, a plurality of stacks and a plurality of first isolation layers alternately arranged in a first direction, where the stack includes a plurality of layers of active structures and a plurality of second isolation layers alternately arranged in a third direction and all extending in a second direction, where the first direction and the second direction are parallel to an upper surface of the base substrate and the third direction is perpendicular to the upper surface of the base substrate; forming a through hole penetrating through the first isolation layer in the third direction, where the through hole exposes the stacks on opposite sides in the first direction; removing a part of the active structure exposed by the through hole to form one first recess on each of opposite sides of remaining active structure in the first direction, where in the third direction, a thickness of the first recess is the same as a thickness of the active structure; forming a lower electrode on an inner wall of the first recess; forming a dielectric layer on a surface of the lower electrode; and forming an upper electrode filling the through hole, where the lower electrode, the upper electrode, and the dielectric layer constitute a capacitor.

The technical schemes provided by the embodiments of the present disclosure at least have the following advantages: the lower electrode is accommodated inside the active structure using the first recess, so that the plurality of lower electrodes in the third direction are separated from each other, and the interconnection therebetween is avoided. Each active structure is provided with two first recesses on opposite sides, respectively, and two capacitors can be correspondingly formed, which is therefore beneficial for increasing the total capacity of the capacitors.

### BRIEF DESCRIPTION OF THE DRAWINGS

The drawings, which are incorporated in and constitute a part of this specification, illustrate embodiments consistent with the present disclosure and, together with the specification, serve to explain the principles of the present disclosure. It is apparent that the drawings in the description below are only for some embodiments of the present disclosure, and for those of ordinary skill in the art, other drawings can be acquired according to the drawings without creative efforts.

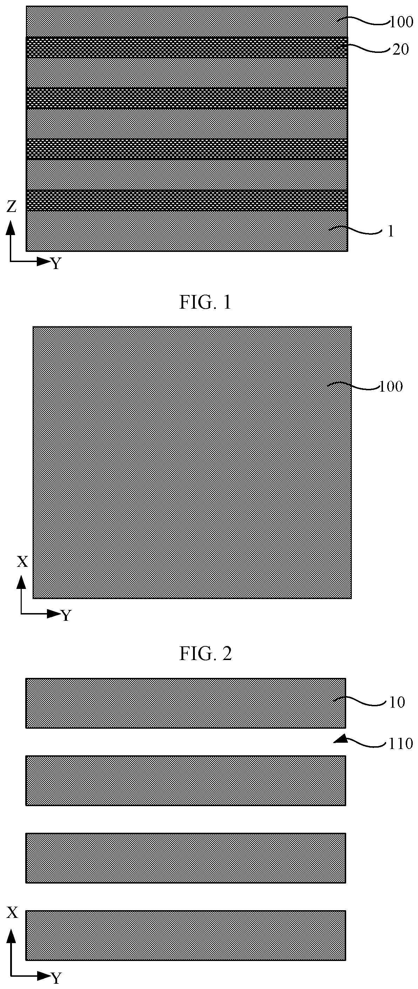

FIGS. 1-27 are schematic structural diagrams corresponding to steps in a method for manufacturing a semiconductor structure provided according to an embodiment of the present disclosure.

### DETAILED DESCRIPTION

As can be seen from the description of the background, the manufacturing process of the capacitor of the 3D DRAM is complicated, and the capacity of the capacitor needs to be improved. It is found by analysis that the main reason is that lower electrodes of a plurality of capacitors need to be spaced apart in a direction perpendicular to the upper surface of the base substrate to prevent the capacitors from causing errors in storing data. However, since the number of stacking layers of capacitors in a 3D DRAM is large, the process of disconnecting lower electrodes of a plurality of capacitors is difficult, and the lower electrodes of the plurality of capacitors may be interconnected. In addition, the contact area between the capacitor and the active structure is small, and thus, the capacity of the capacitor needs to be improved.

Embodiments of the present disclosure provide a semiconductor structure and a method for manufacturing the semiconductor structure, where an active structure is provided therein with two first recesses, the two first recesses are positioned at opposite sides of the active structure, respectively, and a lower electrode of a capacitor is located at an inner wall of the first recess. That is, the first recess can allow the lower electrode to be accommodated inside the active structure, and the lower electrodes adjacent in a third direction are separated from each other by the first recesses, thus avoiding the interconnection of the lower electrodes. In addition, each active structure can be connected to two capacitors, so that the total capacity of the capacitors corresponding to each active structure can be improved.

The embodiments of the present disclosure will be described in detail below with reference to the drawings. However, those of ordinary skill in the art can understand that in the various embodiments of the present disclosure, numerous technical details are set forth in order to enable readers to better understand the embodiments of the present disclosure. However, the technical solutions claimed by the embodiments of the present disclosure can also be implemented even without these technical details and the various changes and modifications based on the following embodiments.

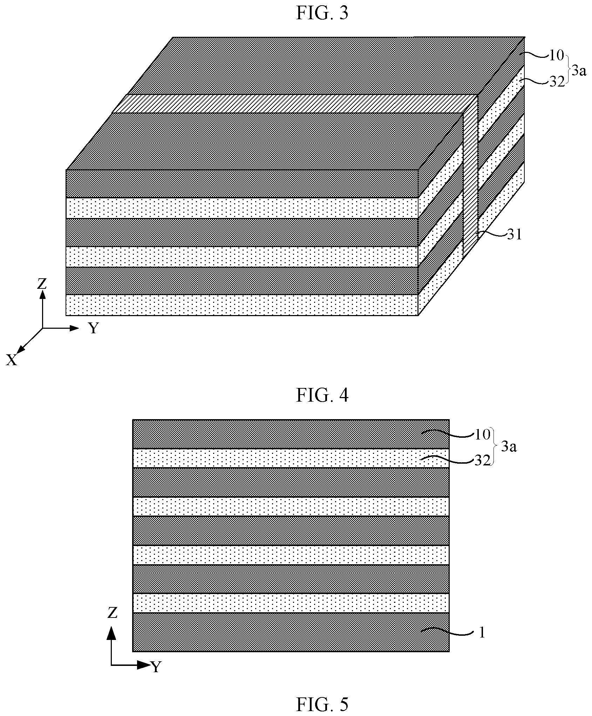

As shown in FIGS. 1-27, an embodiment of the present disclosure provides a method for manufacturing a semiconductor structure. For convenience of description and clear illustration of the steps of the method for manufacturing the semiconductor structure, FIGS. 1-27 are partial schematic structural diagrams of the semiconductor structure. In addition, for the sake of greater intuition, the base substrate is not shown in any of FIGS. 2-4 and FIGS. 6-27, and the base substrate is shown in FIGS. 1 and 5.

First, it should be noted that the semiconductor structure has a first direction X, a second direction Y, and a third direction Z, where the first direction X and the second direction Y are parallel to an upper surface of the base substrate 1, and the third direction Z is perpendicular to the upper surface of the base substrate 1. In some embodiments, the second direction Y and the third direction Z may be perpendicular to each other or close to perpendicular to each other.

In addition, the semiconductor structure includes a first region A and a second region B arranged in sequence in the second direction Y; the first region A is mainly used for forming a transistor, and the second region B is mainly used for forming a capacitor 7. This will be explained in detail later.

Now the method for manufacturing the semiconductor structure will be described in detail with reference to the drawings.

Referring to FIGS. 1-2, FIG. 2 is a cross-sectional view, and FIG. 1 is a top view of the semiconductor structure shown in FIG. 2. A base substrate 1 is provided. A plurality of spacer layers 20 and a plurality of active layers 100 are formed on the base substrate 1, and the spacer layers 20 and the active layers 100 are alternately arranged on the base substrate 1 in a third direction Z.

Illustratively, the base substrate 1 may be a silicon base substrate, the spacer layer 20 may be a germanium-silicon layer, and the active layer 100 may be a silicon layer. The spacer layer 20 and the active layer 100 may be formed on the base substrate 1 using an epitaxial growth process.

Referring to FIG. 3, FIG. 3 is a top view. The spacer layers 20 and the active layers 100 are etched to form a plurality of isolation grooves 110 that are spaced apart. The plurality of isolation grooves 110 are arranged in a first direction X and extend in a second direction Y, and the isolation grooves 110 penetrate through the plurality of spacer layers 20 and the plurality of active layers 100 in the third direction Z. The isolation grooves 110 divide the active layers 100 into a plurality of active structures 10 spaced apart, and the active structures 10 extend along the second direction Y

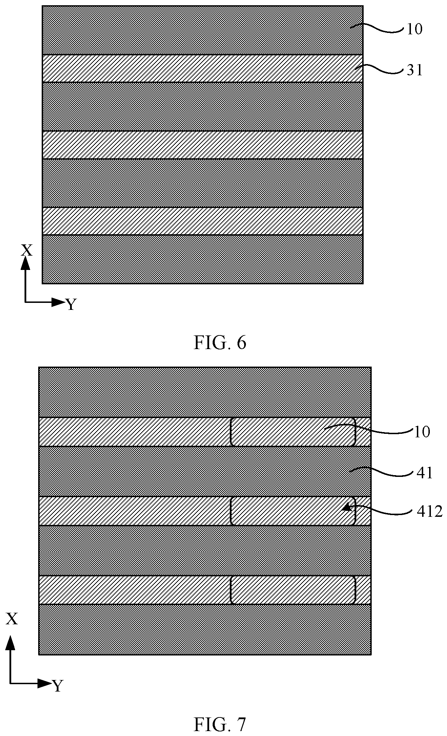

Referring to FIGS. 4-6, FIG. 4 is a partial three-dimensional view, and FIG. 4 shows only one first isolation layer 31; FIG. 5 is a cross-sectional view of the semiconductor structure shown in FIG. 4, and the direction of the cross section is perpendicular to the first direction X; FIG. 6 is a top view of the semiconductor shown in FIG. 4, and FIG. 6 shows a plurality of first isolation layers 31. The spacer layer 20 (referring to FIG. 1) is removed, and a second isolation layer 32 fills the gap between the active structures 10 adjacent in the third direction Z, and the isolation groove 110 is filled with the first isolation layer 31.

Specifically, since the isolation grooves 110 expose the spacer layers 20, an etchant may react with the spacer layers 20 through the isolation grooves 110. Illustratively, an etchant having a relatively large etch selectivity for the spacer layer 20 and the active structure 10 may be used to avoid damaging the active structure 10.

After the spacer layers 20 are removed, a chemical vapor deposition process is used to deposit isolation material layers, where the isolation material layer occupying the space position of the original spacer layer 20 is used as the second isolation layer 32, and the isolation material layer filling the isolation groove 110 is used as the first isolation layer 31. The second isolation layers 32 and the active structures 10 alternately arranged in the third direction Z constitute a stack 3a. The isolation material layer may be silicon oxide.

Up to this point, based on the steps shown in FIGS. 1-6, a plurality of stacks 3a and a plurality of first isolation layers 31 may be formed on the base substrate 1 and are alternately arranged in the first direction X; the stack 3a includes a plurality of layers of active structures 10 and a plurality of second isolation layers 32, which are alternately arranged in the third direction Z and all extend in the second direction Y.

It should be noted that the method for forming the stack 3a and the first isolation layer 31 described above is merely illustrative, and the embodiments of the present disclosure are not limited to the method described above. In other embodiments, the step of forming the stack 3a and the first isolation layer 31 may include: firstly, alternately depositing a plurality of active layers 100 and a plurality of initial second isolation layers on the base substrate 1, and thereafter, etching the active layers 100 and the initial second isolation layers to form isolation grooves 110, where the isolation grooves 110 penetrate through the plurality of active layers 100 and the plurality of initial second isolation layers in the third direction Z and divide the initial second isolation layers into a plurality of second isolation layers 32 spaced apart and divide the active layers 100 into the active structures 10; thereafter, filling the isolation groove 110 with the first isolation layer 31. That is, the first isolation layer 31 and the second isolation layer 32 may be formed in different steps.

Referring to FIG. 7, FIG. 7 is a top-down perspective view. A first mask layer 41 is formed. The first mask layer 41 covers top surfaces of the stacks 3a and the first isolation layers 31, and the first mask layer 41 is provided therein with a plurality of initial through holes 412 spaced apart. The plurality of initial through holes 412 are arranged in the first direction X and located right above the first isolation layers 31, and a width of the initial through hole 412 in the first direction X is equal to a width of the first isolation layer 31 in the first direction X.

Illustratively, firstly, a photoresist layer is formed on the top surfaces of the stacks 3a and the first isolation layers 31 to cover the entire surface; the photoresist layer is exposed and developed to form initial through holes 412. The exposed and developed photoresist layer serves as the first mask layer 41.

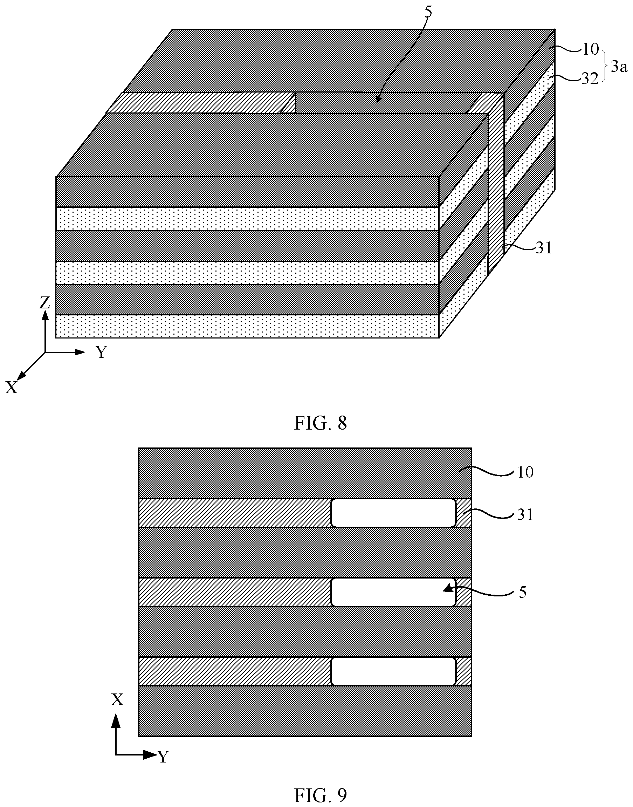

Referring to FIGS. 8 and 9, a through hole 5 penetrating through the first isolation layer 31 in the third direction Z is formed, and the through hole 5 exposes the stacks 3a on opposite sides in the first direction X. It should be noted that the "opposite sides in the first direction X" refers to opposite sides of the through hole 5 arranged in the first direction X. Specifically, with the first mask layer 41 as a mask, the first isolation layer 31 is etched to form the through hole 5. A width of the through hole 5 in the first direction X is equal to the width of the first isolation layer 31. That is, two adjacent stacks 3a and the remaining first isolation layer 31 define the through hole 5. A width of the through hole 5 in the second direction Y is smaller than the width of the first isolation layer 31, and the through hole 5 is provided with remaining first isolation layer 31 on each of opposite sides thereof arranged in the second direction Y After the formation of the through hole 5, the first mask layer 41 is removed.

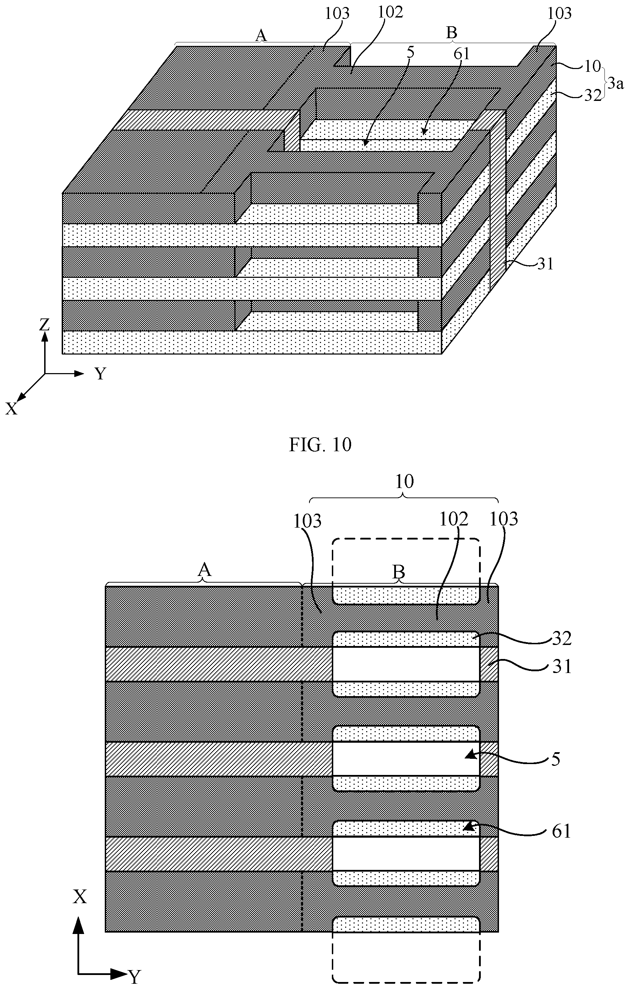

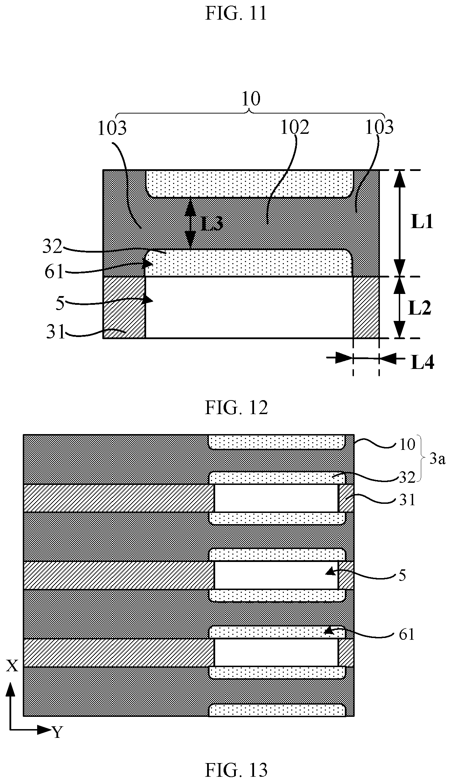

Referring to FIGS. 10-13, FIG. 11 is a top view of the semiconductor structure shown in FIG. 10, FIG. 12 is a partial enlarged view of FIG. 11, and FIG. 13 is another top view different from FIG. 11. A part of the active structures 10 exposed by the through hole 5 is removed to form one first recess 61 on each of opposite sides of the remaining active structure 10 in the first direction X.

Specifically, an etchant of the active structure 10 is introduced into the through hole 5, and the etchant reacts with the exposed active structure 10 and thereby etches the active structure 10 along the first direction X and toward the inside of the active structure. That is, the through hole 5 may serve as a process window for removing a part of the active structure 10.

Referring to FIG. 10, a thickness of the first recess 61 is the same as that of the active structure 10 in the third direction Z. Referring to FIGS. 10-12, a width of an opening of the first recess 61 is the same as the width of the through hole 5 in the second direction Y Referring to FIG. 13, in other embodiments, if etching time is relatively long or a concentration of the etchant is relatively large, the width of the opening of the first recess 61 may also be slightly larger than the width of the through hole 5 in the second direction Y

Referring to FIGS. 11-12, the etched active structure 10 at least includes two longitudinal parts 103 oppositely arranged and one transverse part 102. The transverse part 102 is connected between the two longitudinal parts 103, the transverse part 102 extends along the second direction Y, and the longitudinal part 103 extends along the first direction X, where the transverse part 102 is located between two first recesses 61, i.e., the transverse part 102 is located between two subsequently formed capacitors 7. That is, the two longitudinal parts 103 and the one transverse part 102 may form an "I" shape, and the two longitudinal parts 103 and the one transverse part 102 define two U-shaped first recesses 61. The positional relationship between the active structure 10 and the capacitor will be described in detail later.

It should be noted that one of the longitudinal parts 103 of the active structure 10 is located on a side of the second region B away from the first region A along the second direction Y, and the other one of the longitudinal parts 103 is located on a side of the first region A facing the second region B along the second direction Y That is, one of the longitudinal parts 103 is located in the first region A, and one transverse part 102 and the other longitudinal part 103 are located in the second region B.

Referring to FIG. 12, in the first direction X, a ratio of a width L3 of the transverse part 102 and a width L1 of the longitudinal part 103 is 1:3 to 2:3, such as 1:2. The "width L1 of the longitudinal part 103" may also be understood as the maximum width of the active structure 10 in the first direction X, or may also be understood as a total width of the transverse part 102 and the first recesses 61 on opposite sides thereof in the first direction X, or may also be understood as a width of the active structure 10 before etching.

It should be noted that if the width L3 of the transverse part 102 is too large, the transverse part may occupy the spatial position of the first recess 61 and thereby occupy the spatial position of the lower electrode 71; if the width L3 of the transverse part 102 is too small, the resistance of the active structure 10 may be increased. Allowing the ratio of the width L3 of the transverse part 102 to the width L1 of the longitudinal part 103 to be within the range described above is beneficial for achieving a balance with the two problems described above taken into consideration.

Illustratively, in the first direction X, the width L3 of the transverse part 102 is 30 nm to 60 nm, such as 35 nm, 45 nm, or 50 nm. The width L1 of the longitudinal part 103 is 60 nm to 120 nm, such as 75 nm, 90 nm, or 100 nm. Allowing the widths of the two to be within the ranges described above is beneficial for ensuring that the resistances of the active structure 10 and the subsequently formed lower electrode 71 are both within a relatively small range and that a contact area between the lower electrode 71 and the active structure 10 is relatively large.

With further reference to FIG. 12, in the first direction X, a ratio of a maximum width of the active structure 10 to a width L2 of the first isolation layer 31 is 2: 1 to 1:1. It should be noted that, if the ratio of the maximum width of the active structure 10 to the width L2 of the first isolation layer 31 is too small, the width of the through hole 5 in the first direction X is also correspondingly too large, i.e., the process window for etching the active structure 10 is too large, and therefore, during the formation of the first recesses 61, the active structure 10 may be over-etched, so that the two first recesses 61 are too close, and the width of the remaining active structure 10 is too small; if the ratio of the maximum width of the active structure 10 to the width L2 of the first isolation layer 31 is too large, the width of the through hole 5 in the first direction X is also correspondingly too small, so that the etching degree of the active structure 10 may be insufficient and thereby the filling space of the lower electrode 71 may be affected. Allowing the ratio of two to be within the range described above is beneficial for achieving a balance with the two problems described above taken into consideration.

Illustratively, in the first direction X, the width L2 of the first isolation layer 31 is 40 nm to 120 nm, such as 60 nm, 80 nm, or 100 nm. Allowing the width L2 of the first isolation layer 31 to be within the range described above is beneficial for controlling the etching degree of the active structure 10 to ensure that the first recess 61 has a suitable width in the first direction X, thereby improving the film quality of the lower electrode 71 and ensuring that the active structure 10 has a relatively small resistance.

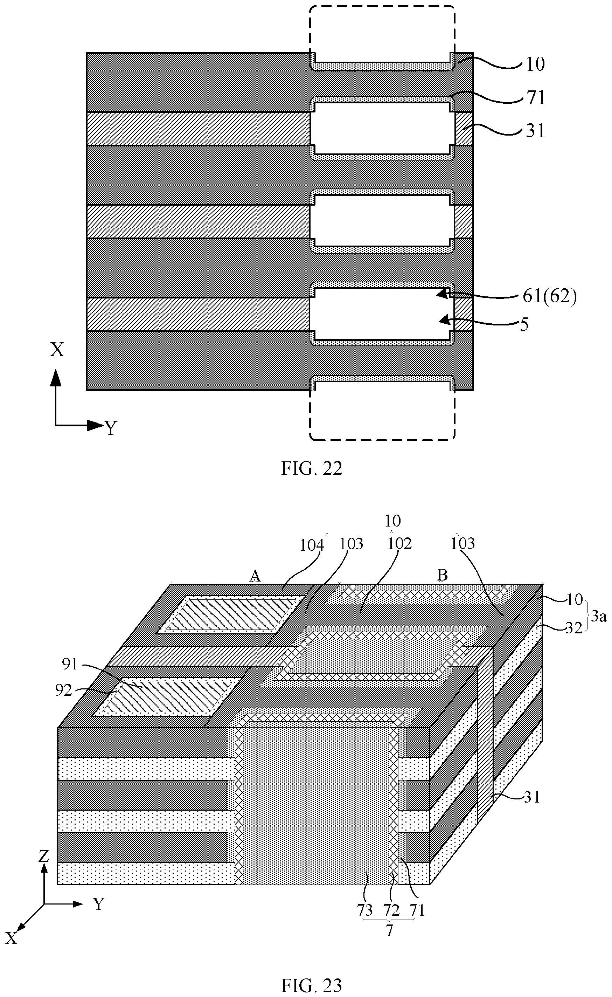

With further reference to FIG. 12, in the second direction Y, a width L4 of the first isolation layer 31 on a side of the through hole 5 away from the first region A is 30 nm to 60 nm, such as 40 nm, 50 nm, or 55 nm. The benefit of this design is that a side of the active structure 10 away from the first region A is prevented from being etched through along the second direction Y during the formation of the first recess 61. That is, it is ensured that a side of the first recess 61 away from the first region A still has remaining active structure 10 (longitudinal part 103). The longitudinal part 103 here can support a subsequently formed capacitor 7 (referring to FIG. 23), and the longitudinal part 103 here can also increase the contact area between the active structure 10 and the capacitor 7, i.e., increase the area of the lower electrode 71. This is beneficial for improving the capacity of the capacitor 7 and reducing the contact resistance between the capacitor 7 and the active structure 10.

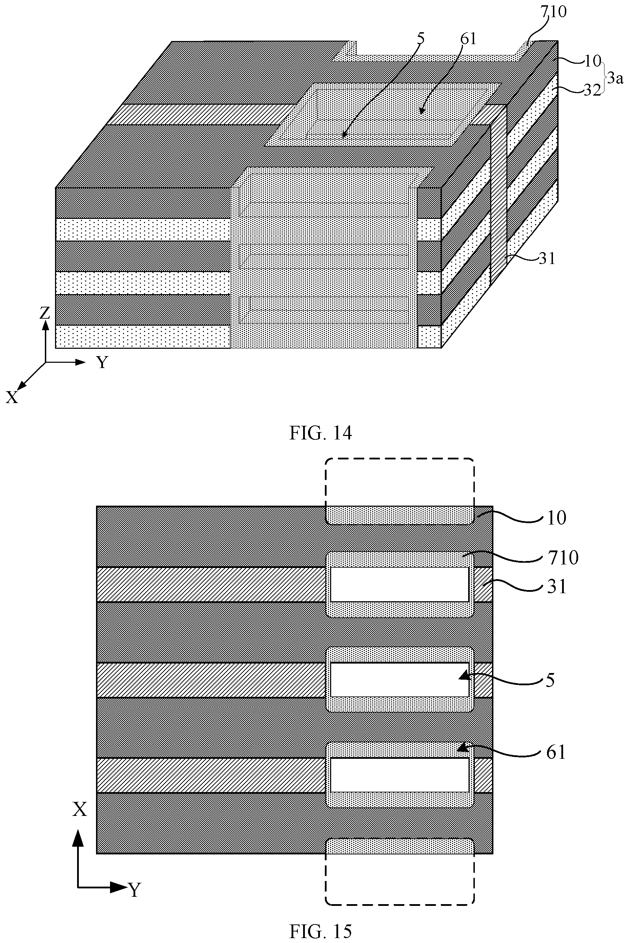

Referring to FIGS. 14-15, an initial lower electrode 710 is formed. The initial lower electrode 710 covers an inner wall of the first recess 61 and a sidewall of the second isolation layer 32 exposed by the through hole 5. In addition, the initial lower electrode 710 also covers a sidewall of the first isolation layer 31 exposed by the through hole 5, and an upper surface and a lower surface of the second isolation layer 32 exposed by the first recess 61, that is, the initial lower electrode 710 is a whole piece in the third direction Z. It should be noted that the initial lower electrode 710 also covers a bottom surface of the through hole 5. Since FIG. 15 does not show the base substrate 1, i.e., the bottom surface of the through hole 5, FIG. 15 does not show the initial lower electrode 710 located at the bottom surface of the through hole 5.

In some embodiments, the initial lower electrode 710 may occupy only a part of the spatial position within the first recess 61. In other embodiments, the initial lower electrode 710 may also completely fill the first recess 61.

Illustratively, a metal film is deposited using a chemical vapor deposition process to serve as the initial lower electrode 710. A material of the initial lower electrode 710 may include one or more of TiN, TiO, and Ru.

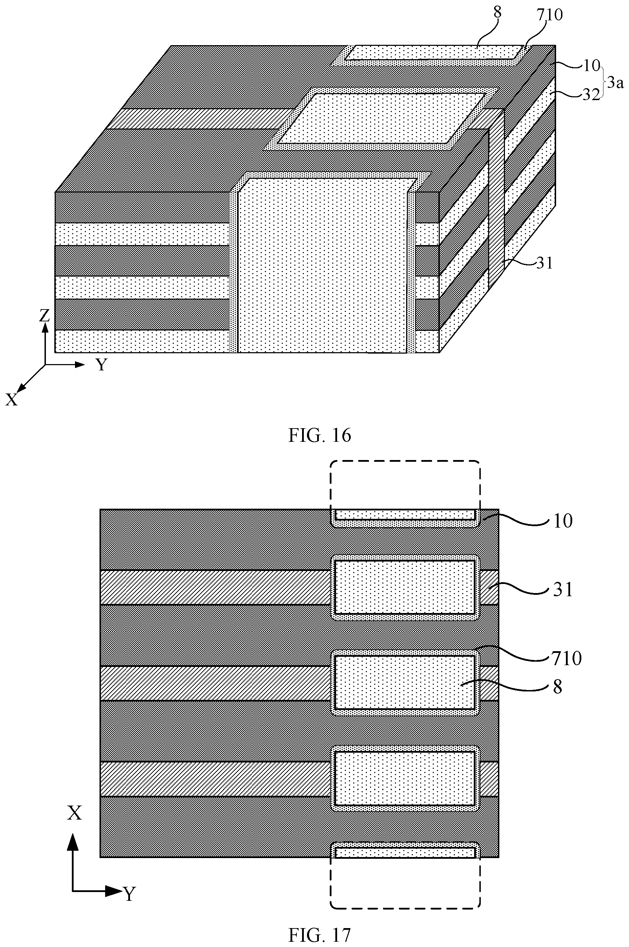

Referring to FIGS. 16-17, a filling layer 8 is formed. The filling layer 8 fills the through hole 5 and covers the initial lower electrode 710. If the first recess 61 is not completely filled by the initial lower electrode 710, a part of the filling layer 8 may also be located in the first recess 61.

Illustratively, an insulating material is deposited in the through hole 5 using a chemical vapor deposition process to serve as the filling layer 8. In some embodiments, the material of the second isolation layer 32 may be the same as the material of the filling layer 8. For example, the material of both is silicon oxide.

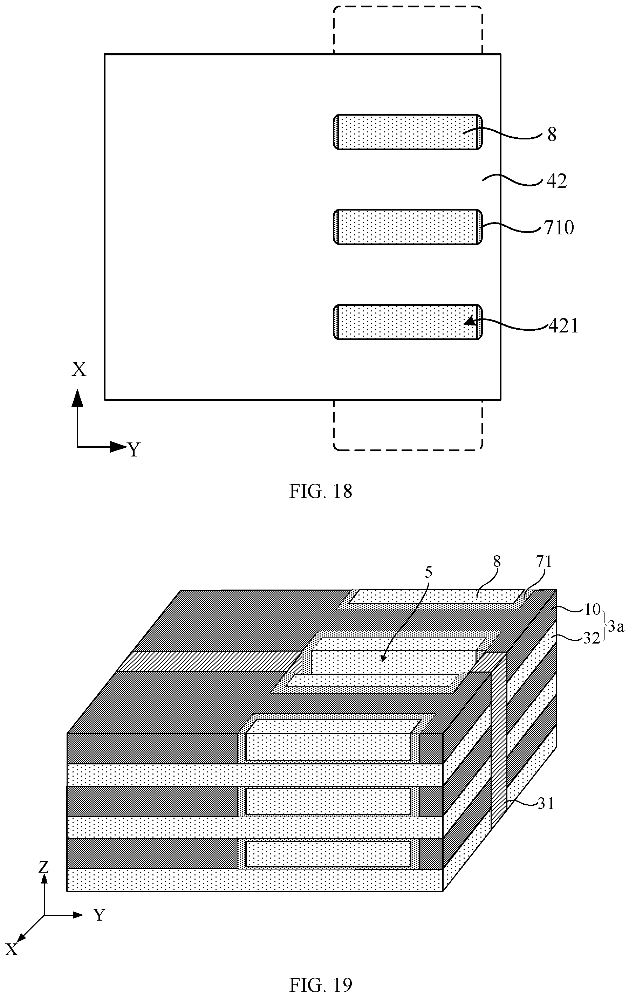

Referring to FIG. 18, a second mask layer 42 is formed on upper surfaces of the stack 3a and the first isolation layer 31, and the pattern of the second mask layer 42 is the same as the pattern of the first mask layer 41 (referring to FIG. 7). That is, the second mask layer 42 has a groove 421, and a size and a position of the groove 421 are the same as those of the initial through hole 412 of the first mask layer 41. The same mask may be used for forming the second mask layer 42 and the first mask layer 41, so that the manufacturing process can be simplified. The groove 421 exposes the filling layer 8 and a part of the initial lower electrode 710 located within the through hole 5.

Referring to FIGS. 19-20, FIG. 20 is a top view of the semiconductor structure shown in FIG. 19, and the filling layer 8 and the initial lower electrode 710 are etched using an anisotropic etching process. That is, the filling layer 8 and the initial lower electrode 710 in the through hole 5 are removed along the third direction Z with the second mask layer 42 as a mask. The anisotropic etching process may be a plasma etching process.

Since the opposite sides of the groove 421 in the first direction X are aligned with the opposite sides of the second isolation layer 32 in the first direction X, the initial lower electrode 710 located at the sidewall of the second isolation layer 32 can be removed by the anisotropic etching process. In addition, since the opposite sides of the groove in the second direction Y are aligned with the opposite sides of the through hole 5 in the second direction Y, the initial lower electrode 710 located at the sidewall of the first isolation layer 31 can be removed by the anisotropic etching process. Therefore, the initial lower electrode 710 located outside the first recess 61 is removed, and the remaining initial lower electrode 710 serves as a lower electrode 71. That is, the initial lower electrode 710 located at the inner wall of the first recess 61 serves as the lower electrode 71. The plurality of lower electrodes 71 arranged in the third direction Z are separated from each other.

It should be noted that the filling layer 8 may protect the initial lower electrode 710 located in the first recess 61 to avoid removing the initial lower electrode 710 in the first recess 61 when removing the initial lower electrode 710 outside the first recess 61, thereby ensuring the film quality of the lower electrode 71 and ensuring that it has a relatively low resistance.

As can be seen from FIGS. 19-20, the filling layer 8 is also located in the first recess 61. This part of the filling layer 8 cannot be removed by the anisotropic etching process, and an isotropic etching process can be used in the subsequent steps to remove then this part of the filling layer 8 to increase the area of the exposed lower electrode 71. In other embodiments, the filling layer 8 may be located only in the through hole 5, and thus the anisotropic etching process described above may remove all of the filling layer 8.

Up to this point, based on the steps shown in FIGS. 14-20, the lower electrode 71 may be formed on the inner wall of the first recess 61. However, the steps described above are only illustrative, and the embodiments of the present disclosure are not limited thereto. For example, in other embodiments, the initial lower electrode 710 may completely fill the first recess 61, and in the subsequent steps, the anisotropic etching process may be directly used to etch back the initial lower electrode 710 outside the first recess 61 without forming the filling layer 8. Since a thickness of the initial lower electrode 710 in the first recess 61 is relatively large and the anisotropic etching process is mainly performed along the third direction Z, the initial lower electrode 710 in the first recess 61 is not completely removed.

That is, the concave shape of the first recess 61 can protect the initial lower electrode 710 in the first recess 61 from being removed but can facilitate the removal of the initial lower electrode 710 outside the first recess 61. This may allow the lower electrodes 71 finally formed to be disconnected from each other in the third direction Z, that is, the plurality of lower electrodes 71 are separated from each other.

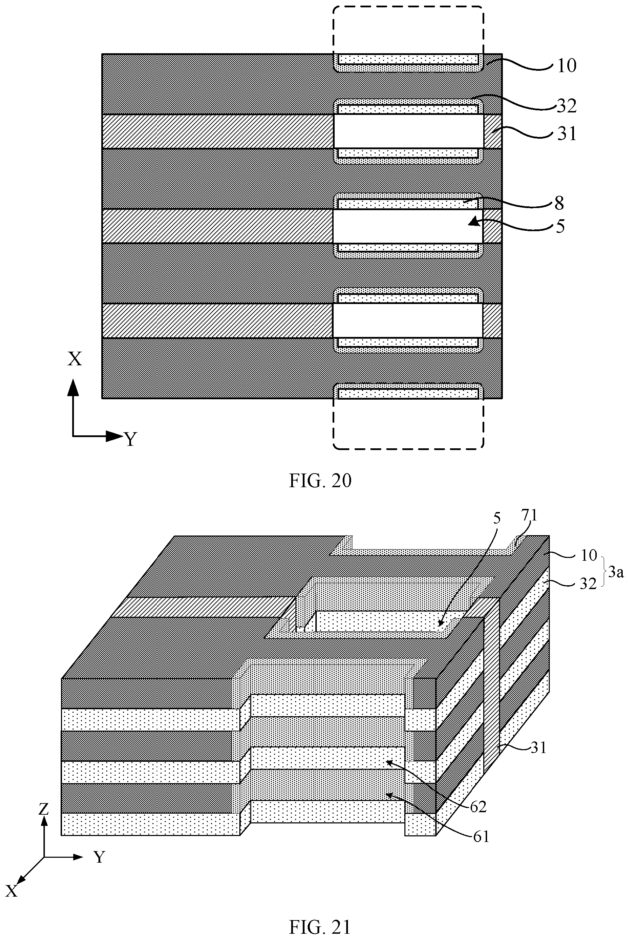

Referring to FIG. 21, after the anisotropic etching process is performed, the remaining filling layer 8 in the first recess 61 is removed using the isotropic etching process. Illustratively, the isotropic etching process may be a wet etching process.

In some embodiments, since the material of the second isolation layer 32 and the material of the filling layer 8 are the same, in the isotropic etching process, a part of the second isolation layer 32 exposed by the through hole 5 is also removed to form one second recess 62 on each of opposite sides of the remaining second isolation layer 32, and the second recess 62 and the first recess 61 are lined up and in communication with each other in the third direction Z. That is, since the through hole 5 exposes a part of the sidewall of the second isolation layer 32, the etchant also etches along the first direction X and toward the inside of the second isolation layer 32. In this way, the space for subsequently filling an upper electrode 73 can be increased, thereby reducing a resistance of the upper electrode 73. In some embodiments, an inner wall of the second recess 62 may be aligned with the sidewall of the lower electrode 71 in the third direction Z.

It should be noted that since a part of the second isolation layer 32 is removed, the lower electrode 71 on the upper surface and the lower surface of this part of the second isolation layer 32 falls off due to a lose of support. Therefore, a cleaning process may be used to remove the lower electrode 71 fallen off.

In other embodiments, the material of the second isolation layer 32 may be different from the material of the filling layer 8. In this way, when the filling layer 8 is removed, the second isolation layer 32 and the lower electrodes 71 on the upper and lower surfaces thereof are not removed. In this way, the area of the lower electrode 71 is larger, which is beneficial for increasing the capacity of the capacitor 7.

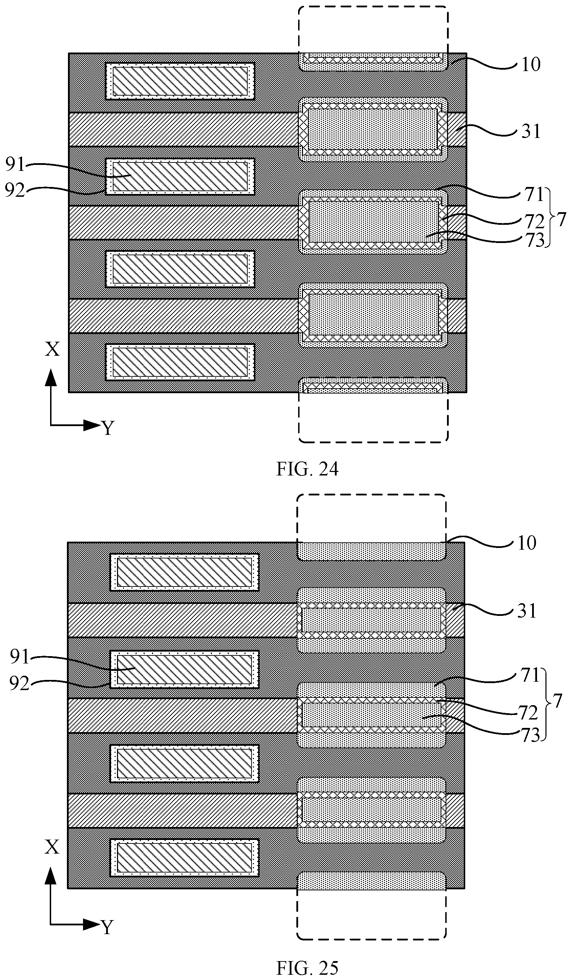

Referring to FIGS. 23-26, FIG. 24 shows a top view of the semiconductor structure shown in FIG. 23, and FIGS. 25-26 show two other top views different from FIG. 24, respectively. A dielectric layer 72 is formed on the surface of the lower electrode 71. Illustratively, a high dielectric constant layer is deposited on the surface of the lower electrode 71 using a chemical vapor deposition process to serve as the dielectric layer 72. Illustratively, the dielectric layer 72 may be oxide or oxynitride of Hf, Zr, Ta, or other materials.

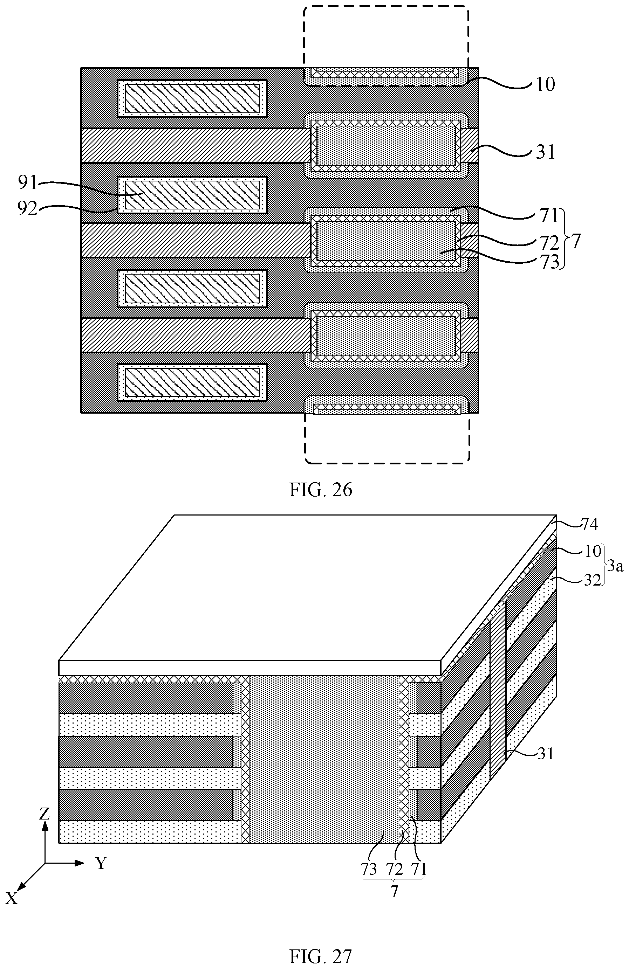

Referring to FIG. 27, it should be noted that during the deposition process, the dielectric layer 72 is also formed on the upper surfaces of the stacked 3a and the first isolation layer 31 and covers a top surface of the lower electrode 71 located at an uppermost layer. For the sake of greater intuition, this part of dielectric layer 72 is not shown in any of FIGS. 23-26. That is, after the dielectric layer 72 is deposited, a planarization process may be performed to improve the flatness of the top surface of the semiconductor structure. During the planarization process, it is not necessary to expose the stack 3a, the upper surface of the first isolation layer 31, and the top surface of the lower electrode 71 at the uppermost layer, that is, the top surface of the dielectric layer 72 is arranged higher than the top surface of the lower electrode 71 at the uppermost layer. This can isolate an electrode layer 74 to be formed later from the lower electrode 71.

With further reference to FIGS. 23-26, in some embodiments, since the lower electrode 71 also exposes the inner wall of the second recess 62, the dielectric layer 72 may also be located on the inner wall of the second recess 62, that is, the dielectric layer 72 also covers a part of the sidewalls of the first isolation layer 31 and the second isolation layer 32, and the dielectric layer 72 is a whole piece in the third direction Z.

In other embodiments, the dielectric layer 72 may be only located in the first recess 61 and does not cover a part of the sidewalls of the first isolation layer 31 and the second isolation layer 32, and the dielectric layer 72 is in the form of disconnected parts in the third direction Z. Specifically, after the initial lower electrode 710 is formed, an initial dielectric layer is formed on the surface of the initial lower electrode 710, and thereafter the filling layer 8 is formed within the through hole 5, and the filling layer 8 also covers the initial dielectric layer. After the filling layer 8 is formed, anisotropic etching is performed to remove the initial dielectric layer and the initial lower electrode 710 located outside the first recess 61, the remaining initial dielectric layer serves as the dielectric layer 72, and the remaining initial lower electrode 710 serves as the lower electrode 71. In this case, the dielectric layer 72 is in the form of disconnected parts in the third direction Z.

Referring to FIG. 24, when the lower electrode 71 does not completely fill the first recess 61, a part of the dielectric layer 72 may also be located in the first recess 61. Referring to FIG. 25, when the lower electrode 71 completely fills the first recess 61, the dielectric layer 72 is entirely located in the through hole 5. In addition, referring to FIGS. 24-25, when a width of the opening of the first recess 61 is equal to the width of the through hole 5 in the second direction Y, an edge of the lower electrode 71 is aligned with an edge of the dielectric layer 72. Referring to FIG. 26, when the width of the opening of the first recess 61 is slightly larger than the width of the through hole 5 in the second direction Y, the edge of the lower electrode 71 is protruded with respect to the edge of the dielectric layer 72.

With further reference to FIGS. 23-26, an upper electrode 73 filling the through hole 5 is formed, and the lower electrode 71, the upper electrode 73, and the dielectric layer 72 constitute the capacitor 7. Illustratively, the upper electrode 73 is formed using a chemical vapor deposition process, and a material of the upper electrode 73 may be the same as the material of the lower electrode 71.

It should be noted that the upper electrode 73 is a full-sheet electrode extending in the third direction Z since the upper electrodes 73 of a plurality of capacitors 7 need to be connected to the same signal. It should be noted that the through hole 5 can expose the active structure 10 to form the first recesses 61 on opposite sides of the active structure 10; the through hole 5 may also serve as a filling space for the upper electrode 73. Since the through hole 5 penetrates through the stack 3a in the third direction Z, the upper electrode 73 formed by filling the through hole 5 is also connected as a whole. Therefore, the structure of the semiconductor structure is simpler, and the forming process can be simplified.

With further reference to FIG. 23, the longitudinal parts 103 and the transverse part 102 are in contact with sidewalls of the lower electrodes 71 of two capacitors 7. In this way, each capacitor 7 can be in contact with the active structure 10 in three directions, so that the contact area between the active structure 10 and the capacitor 7 is increased, and thereby the contact resistance is reduced and the operation speed of the semiconductor structure is improved. In other words, the lower electrode 71 of the capacitor 7 has a relatively large area, which is beneficial for increasing the capacity of the capacitor 7.

In some embodiments, referring to FIGS. 23, 24, and 26, a part of the upper electrode 73 may also be located within the first recess 61 and the second recess 62, and referring to FIG. 25, the upper electrode 73 may be located only within the through hole 5.

Referring to FIG. 27, an electrode layer 74 is formed. The electrode layer 74 is located on the stack 3a and the first isolation layer 31 and covers the dielectric layer 72, and the electrode layer 74 is also connected to a plurality of upper electrodes 73. Illustratively, the electrode layer 74 is formed by a chemical vapor deposition method, and materials of the electrode layer 74 may include conductive materials such as silicon germanium, polysilicon, or metal. The electrode layer 74 is also electrically connected to a peripheral circuit.

The electrode layer 74 is separated from the lower electrode 71 by the dielectric layer 72, thereby preventing the upper electrode 73 and the lower electrode 71 from being electrically connected to each other and causing a short circuit.

The method for manufacturing the semiconductor structure further includes forming a word line 91. In some embodiments, the word line 91 may be formed after the capacitor 7 is formed. In other embodiments, the word line 91 may also be formed before the capacitor 7 is formed, that is, the word line 91 may be formed before the through hole 5 is formed.

Illustratively, referring to FIG. 23, the word line 91 penetrating through the stack 3a is formed. The word line 91 extends along the third direction Z, and the word line 91 is located in the first region A. The active structure 10 further includes a surrounding part 104. The surrounding part 104 is located in the first region A, and the surrounding part 104 and the longitudinal parts 103 are connected and jointly surround the word line 91. The dotted line in FIG. 23 is used to illustrate the boundary between the longitudinal part 103 and the surrounding part 104 in the first region A. A gate dielectric layer 92 is also provided on a surface of the word line 91, and the surrounding part 104 and the longitudinal parts 103 of the first region A also surround the gate dielectric layer 92 and are in contact with a surface of the gate dielectric layer 92. That is, one active structure 10 and the gate dielectric layer 92 and the word line 91 which are in contact with the active structure 10 constitute one transistor, and the transistor and two capacitors 7 in the active structure 10 constitute one memory cell. The transistor described above is called a channel-all-around (CAA) transistor. Furthermore, the semiconductor structure may also include a third region (not shown in the figure), and the third region, the first region A, and the second region B are arranged in the first direction X in sequence, that is, the first region A is located between the third region and the second region B. The third region is provided therein with a bit line extending along the first direction X, and one bit line is connected to a plurality of active structures 10 in the same layer.

In other embodiments, the word line 91 may also extend along the first direction X, and the word line 91 surrounds the active structure 10 in the first region A. Such a transistor is called a gate-all-around (GAA) transistor. In addition, the bit line of the third region may extend along the third direction Z, and one bit line is connected to a plurality of layers of active structures 10 in the same stack 3a.

In other embodiments, the transistor may also have a single-sided gate structure. That is, the word line 91 is in contact with the active structure 10 through only one side. The above description is merely illustrative, and the specific type of transistors is not limited in the embodiments of the present disclosure.

In summary, in the embodiment of the present disclosure, two first recesses 61 are formed in the active structure 10, and the first recesses 61 are used to separate adjacent lower electrodes 71 in the third direction Z to avoid interconnection between the adjacent lower electrodes 71. The first recess 61 is beneficial for increasing the surface area of the lower electrode 71 and the contact area of the lower electrode 71 and the active structure 10, thereby being beneficial for increasing the capacity of the capacitor 7 and reducing the contact resistance of the capacitor 7 and the active structure 10.

As shown in FIGS. 23-27, another embodiment of the present disclosure further provides a semiconductor structure. The semiconductor structure can be manufactured by the manufacturing method described above, and reference may be made to the embodiments described above for the detailed description of the semiconductor structure, which will not be repeated here.

Referring to FIGS. 23-26, the semiconductor structure includes a base substrate 1. The base substrate 1 is provided thereon with a plurality of stacks 3a and a plurality of first isolation layers 31 alternately arranged in a first direction X. The stack 3a includes a plurality of layers of active structures 10 and a plurality of second isolation layers 32 alternately arranged in a third direction Z and all extending in a second direction Y, where the first direction X and the second direction Y are parallel to an upper surface of the base substrate 1, and the third direction Z is perpendicular to the upper surface of the base substrate 1. The active structure 10 is provided with two first recesses 61 therein, and the two first recesses 61 are respectively located on opposite sides of the active structure 10 in the first direction X. In the third direction Z, a thickness of the first recess 61 is the same as a thickness of the active structure 10. The active structure 10 is provided with one capacitor 7 on each of opposite sides thereof arranged in the first direction X, and the capacitor 7 includes an upper electrode 73, a dielectric layer 72, and a lower electrode 71, where the lower electrode 71 is located on an inner wall of the first recess 61, the upper electrode 73 is located between two adjacent stacks 3a and is arranged opposite to the first recess 61, the upper electrode 73 also penetrates through the first isolation layer 31, and the dielectric layer 72 is located between the lower electrode 71 and the upper electrode 73.

Each active structure 10 is connected to two capacitors 7, which is thereby beneficial for increasing the storage capacity of each memory cell. Compared to the lower electrode 71 located on the outer surface of the active structure 10, the concave structure of the first recess 61 may enable the lower electrode 71 to be located inside the active structure 10 and thereby to avoid erroneous electrical connection between the lower electrodes 71 adjacent to each other in the third direction Z. In addition, the forming process of the first recess 61 is relatively simple, i.e., only etching the active structure 10 exposed by the through hole 5 using the anisotropic etching process, which is beneficial for reducing the production cost.

In some embodiments, referring to FIG. 23, the active structure 10 includes two longitudinal parts 103 oppositely arranged and one transverse part 102. The transverse part 102 is connected between the two longitudinal parts 103, the transverse part 102 extends along the second direction Y, and the longitudinal part 103 extends along the first direction X, where the transverse part 102 is located between two capacitors 7, and the longitudinal parts 103 and the transverse part 102 are in contact with sidewalls of the lower electrodes 71 of the two capacitors 7. That is, the two longitudinal parts 103 and the transverse part 102 may form an "I" shape. In this way, each capacitor 7 can be in contact with the active structure 10 in three directions, so that the contact area between the active structure 10 and the capacitor 7 is increased, and thereby the contact resistance is reduced and the operation speed of the semiconductor structure is improved.

With further reference to FIG. 23, the semiconductor structure includes a first region A and a second region B arranged in sequence in the second direction Y The capacitor 7 and the transverse part 102 are located within the second region B. One longitudinal part 103 of the active structure 10 is located on a side of the second region B away from the first region A along the second direction Y, and the other longitudinal part 103 is located on a side of the first region A facing the second region B along the second direction Y That is, the active structure 10 extends along the second direction Y in the first region A and the second region B, where one of the longitudinal parts 103 is located in the first region A, and one transverse part 102 and the other longitudinal part 103 are located in the second region B. The two longitudinal parts 103 and the one transverse part 102 form an "I" shape together to increase the area of the lower electrode 71, thereby increasing the capacity of the capacitor.

The semiconductor structure further includes a word line 91 penetrating through the stack 3a. The word line 91 extends along the third direction Z, and the word line 91 is located in the first region A. The active structure 10 further includes a surrounding part 104. The surrounding part 104 is located in the first region A, and the surrounding part 104 and the longitudinal parts 103 are connected and jointly surround the word line 91. A gate dielectric layer 92 is also provided on a surface of the word line 91, and the surrounding part 104 and the longitudinal parts 103 of the first region A also surround the gate dielectric layer 92 and are in contact with a surface of the gate dielectric layer 92. This structure is called a channel-all-around (CAA) transistor and is beneficial for increasing the channel length. Furthermore, the semiconductor structure may also include a third region (not shown in the figure), and the third region, the first region A, and the second region B are arranged in sequence in the first direction X. The third region is provided therein with a bit line extending along the first direction X.

It should be noted that although the active structure 10 is divided into different parts such as the longitudinal part 103, the transverse part 102, and the surrounding part 104, the active structure 10 is still an integral structure and these parts are connected together. The division described above is to facilitate understanding of the specific shape of the active structure 10.

In the first direction X, a ratio of a width L3 of the transverse part 102 to a width L1 of the longitudinal part 103 (referring to FIG. 12) is 1:3 to 2:3. Allowing the ratio of the widths of the two to be within the range described above is beneficial for ensuring that the transverse part 102 has a relatively small resistance and for ensuring a filling space of the lower electrode 71.

Illustratively, the width of the transverse part 102 in the first direction X is 30 nm to 60 nm, such as 35 nm, 45 nm, or 50 nm. The maximum width of the active structure 10 is 60 nm to 120 nm, such as 75 nm, 90 nm, or 100 nm. Allowing the widths of the two to be within the ranges described above is beneficial for ensuring that the resistances of the lower electrode 71 and the active structure 10 are both within a relatively small range and that a contact area between the lower electrode 71 and the active structure 10 is relatively large.

In some embodiments, in the first direction X, a ratio of the maximum width of the active structure 10 to a width L2 of the first isolation layer 31 (referring to FIG. 12) is 2:1 to 1:1.

Illustratively, in the first direction X, the width of the first isolation layer 31 is 40 nm to 120 nm, such as 60 nm, 80 nm, or 100 nm. Reference may be made to the embodiments described above for the detailed description of the above data and the effects thereof, which will not be repeated here.

Referring to FIGS. 23-24 and 26, a part of the dielectric layer 72 is also located within the first recess 61. A part of the upper electrode 73 is also located within the first recess 61. In other embodiments, referring to FIG. 25, the dielectric layer 72 and the upper electrode 73 may be located only in the through hole 5, not in the first recess 61. In other embodiments, a part of the dielectric layer 72 may be located in the first recess 61, and the upper electrode 73 may be located only in the through hole 5, but not in the first recess 61.

In some embodiments, the second isolation layer 32 is provided with two second recesses 62 therein (referring to FIG. 21), and the two second recesses 62 are respectively located at opposite sides of the second isolation layer 32 arranged in the first direction X; in the third direction Z, a thickness of the second recess 62 is the same as a thickness of the active structure 10; the first recess 61 and the second recess 62 are also lined up in the third direction Z. That is, the first recess 61 is in communication with the second recess 62, and the second recess 62 can be configured to accommodate the dielectric layer 72 and the upper electrode 73, which is beneficial for increasing the filling space of the upper electrode 73 and reducing the resistance thereof.

In some embodiments, in the third direction Z, an inner wall of the second recess 62 may be aligned with a sidewall of the lower electrode 71 within the first recess 61. That is, the space inside the second recess 62 is relatively sufficient, which is beneficial for increasing the filling space of the upper electrode 73.

Referring to FIG. 27, the semiconductor structure further includes an electrode layer 74. The electrode layer 74 is located on the stack 3a and the first isolation layer 31 and is connected to a plurality of upper electrodes 73. Therefore, the plurality of upper electrodes 73 may be connected to a peripheral circuit through the electrode layer 74.

It should be noted that a part of the dielectric layer 72 may be located on a top surface of the lower electrode 71 at the uppermost layer. That is, this part of the dielectric layer 72 can separate the electrode layer 74 from the lower electrode 71 and prevent the electrode layer 74 from being connected to the upper electrode 73 and the lower electrode 71 at the same time.

In summary, in the embodiments of the present disclosure, the active structure is provided with two first recesses therein, and the lower electrode of the capacitor is located on an inner wall of the first recess. That is, the first recess can allow the lower electrode to be accommodated inside the active structure, and the lower electrodes adjacent in a third direction are separated from each other by the first recesses, thus avoiding the interconnection of the lower electrodes. In addition, each active structure can be connected to two capacitors, thereby being beneficial for improving the total capacity of a plurality of capacitors.

In the description of this specification, description with reference to the term "some embodiments", "illustratively", or the like means that a specific feature, structure, material, or characteristic described in conjunction with the embodiment or example is included in at least one embodiment or example of the present disclosure. In this specification, the schematic description of the above terms does not necessarily refer to the same embodiment or example. Moreover, the specific feature, structure, material, or characteristic described may be combined in a suitable manner in any one or more embodiments or examples. Moreover, different embodiments or examples and features of different embodiments or examples described in this specification can be combined by those skilled in the art, as long as they do not contradict each other.

Although the embodiments of the present disclosure have been shown and described above, it should be understood that the embodiments described above are illustrative and should not be construed as limiting the present disclosure, and that changes, modifications, substitutions, and alterations to the embodiments described above may be made by those of ordinary skill in the art within the scope of the present disclosure and therefore changes and modifications made based on the claims and the specification of the present disclosure shall all fall within the scope covered by the present disclosure.

## Claims

1. A semiconductor structure, comprising:
a base substrate (1), the base substrate (1) being provided thereon with a plurality of stacks (3a) and a plurality of first isolation layers (31) alternately arranged in a first direction (X), wherein
the stack (3a) comprises a plurality of layers of active structures (10) and a plurality of second isolation layers (32) alternately arranged in a third direction (Z) and all extending in a second direction (Y), wherein the first direction (X) and the second direction (Y) are parallel to an upper surface of the base substrate (1) and the third direction (Z) is perpendicular to the upper surface of the base substrate (1);
the active structure (10) is provided with two first recesses (61) therein, and the two first recesses (61) are respectively located on opposite sides of the active structure (10) in the first direction (X); in the third direction (Z), a thickness of the first recess (61) is the same as a thickness of the active structure (10);
the active structure (10) is provided with one capacitor (7) on each of opposite sides thereof in the first direction (X), and the capacitor (7) comprises an upper electrode (73), a dielectric layer (72), and a lower electrode (71), wherein the lower electrode (71) is located on an inner wall of the first recess (61), the upper electrode (73) is located between two adjacent stacks (3a) and is arranged opposite to the first recess (61), and the upper electrode (73) also penetrates through the first isolation layer (31); the dielectric layer (72) is located between the lower electrode (71) and the upper electrode (73).

2. The semiconductor structure according to claim 1, wherein the active structure (10) comprises two longitudinal parts (103) oppositely arranged and one transverse part (102); the transverse part (102) is connected between the two longitudinal parts (103), the transverse part (102) extends along the second direction (Y), and the longitudinal part (103) extends along the first direction (X),
wherein the transverse part (102) is located between two capacitors (7); the longitudinal parts (103) and the transverse part (102) are in contact with sidewalls of the lower electrodes (71) of the two capacitors (7).

3. The semiconductor structure according to claim 2, comprising a first region (A) and a second region (B) arranged in sequence in the second direction (Y), wherein the capacitor (7) and the transverse part (102) are located within the second region (B), one of the longitudinal parts (103) of the active structure (10) is located on a side of the second region (B) away from the first region (A) along the second direction (Y), and the other one of the longitudinal parts (103) is located on a side of the first region (A) facing the second region (B) along the second direction (Y);
the semiconductor structure further comprises a word line (91) penetrating through the stack (3a), and the word line (91) extends along the third direction (Z);
the word line (91) is located in the first region (A);
the active structure (10) further comprises a surrounding part (104); the surrounding part (104) is located in the first region (A) and the surrounding part (104) and the longitudinal parts (103) jointly surround the word line (91).

4. The semiconductor structure according to claim 2 or 3, wherein in the first direction (X), a ratio of a width of the transverse part (102) to a width of the longitudinal part (103) is 1:3 to 2:3.

5. The semiconductor structure according to any one of claims 2-4, wherein in the first direction (X), the width of the transverse part (102) is 30 nm to 60 nm, and the width of the longitudinal part (103) is 60 nm to 120 nm.

6. The semiconductor structure according to any one of claims 1-5, wherein in the first direction (X), a ratio of a maximum width of the active structure (10) to a width of the first isolation layer (31) is 2: 1 to 1:1.

7. The semiconductor structure according to any one of claims 1-6, wherein the second isolation layer (32) is provided with two second recesses (62) therein, and the two second recesses (62) are respectively located at opposite sides of the second isolation layer (32) in the first direction (X);
in the third direction (Z), a thickness of the second recess (62) is the same as the thickness of the active structure (10);
the first recess (61) and the second recess (62) are also lined up in the third direction (Z).

8. The semiconductor structure according to any one of claims 1-7, wherein a part of the dielectric layer (72) is also located within the first recess (61).

9. The semiconductor structure according to any one of claims 1-8, wherein a part of the upper electrode (73) is also located within the first recess (61).

10. The semiconductor structure according to any one of claims 1-9, further comprising an electrode layer (74), wherein the electrode layer (74) is located on the stack (3a) and the first isolation layer (31) and is connected to a plurality of upper electrodes (73).

11. A method for manufacturing a semiconductor structure, comprising: providing a base substrate (1) and forming, on the base substrate (1), a plurality of stacks (3a) and a plurality of first isolation layers (31) alternately arranged in a first direction (X), wherein
the stack (3a) comprises a plurality of layers of active structures (10) and a plurality of second isolation layers (32) alternately arranged in a third direction (Z) and all extending in a second direction (Y), wherein the first direction (X) and the second direction (Y) are parallel to an upper surface of the base substrate (1) and the third direction (Z) is perpendicular to the upper surface of the base substrate (1);
forming a through hole (5) penetrating through the first isolation layer (31) in the third direction (Z), wherein the through hole (5) exposes the stacks (3a) on opposite sides in the first direction (X);
removing a part of the active structure (10) exposed by the through hole (5) to form one first recess (61) on each of opposite sides of remaining active structure (10) in the first direction (X), wherein in the third direction (Z), a thickness of the first recess (61) is the same as a thickness of the active structure (10);
forming a lower electrode (71) on an inner wall of the first recess (61);
forming a dielectric layer (72) on a surface of the lower electrode (71); and
forming an upper electrode (73) filling the through hole (5), wherein the lower electrode (71), the upper electrode (73), and the dielectric layer (72) constitute a capacitor (7).

12. The method for manufacturing a semiconductor structure according to claim 11, wherein the step of forming the lower electrode (71) on the inner wall of the first recess (61) comprises:
forming an initial lower electrode (710), wherein the initial lower electrode (710) covers the inner wall of the first recess (61) and a sidewall of the second isolation layer (32) exposed by the through hole (5); and
removing the initial lower electrode (710) on the sidewall of the second isolation layer (32), wherein remaining initial lower electrode (710) serves as the lower electrode (71).

13. The method for manufacturing a semiconductor structure according to claim 12, further comprising, before removing the initial lower electrode (710) on the sidewall of the second isolation layer (32):
forming a filling layer (8), wherein the filling layer (8) fills the through hole (5) and covers the initial lower electrode (710); and
etching the filling layer (8) and the initial lower electrode (710) using an anisotropic etching process.

14. The method for manufacturing a semiconductor structure according to claim 13, wherein the filling layer (8) is also located within the first recess (61); after the anisotropic etching process is performed, remaining filling layer (8) in the first recess (61) is removed using an isotropic etching process.

15. The method for manufacturing a semiconductor structure according to claim 14, wherein a material of the second isolation layer (32) and a material of the filling layer (8) are the same;
in the isotropic etching process, a part of the second isolation layer (32) exposed by the through hole (5) is also removed to form one second recess (62) on each of opposite sides of remaining second isolation layer (32), and the second recess (62) and the first recess (61) are lined up and in communication with each other in the third direction Z.

16. The method for manufacturing a semiconductor structure according to any one of claims 11-15, wherein the dielectric layer (72) is also formed on upper surfaces of the stack (3a) and the first isolation layer (31) and covers a top surface of the lower electrode (71) located at an uppermost layer.

17. The method for manufacturing a semiconductor structure according to claim 16, further comprising: forming an electrode layer (74), wherein the electrode layer (74) is located on the stack (3a) and the first isolation layer (31) and covers the dielectric layer (72), and the electrode layer (74) is also connected to a plurality of upper electrodes (73).
